# EUROPEAN PATENT APPLICATION

(11) **EP 4 763 594 A1**
(43) Date of publication of application: **24.06.2026**
(21) Application number: 25222774.9
(22) Date of filing: 11.12.2025
(51) Int. Cl.: B60L 53/24

(54) **SYSTEM FOR A VEHICLE, ASSEMBLY, AND METHOD FOR DETECTING A CONNECTIONN STATE OF A SWITCH DEVICE OF A CHARGING CIRCUIT**

(30) Priority: 20.12.2024 DE 102024139416
(71) Applicant: Valeo eAutomotive Germany GmbH, 91056 Erlangen (DE)
(72) Inventor: Hellmuth, Kilian, 91056 Erlangen (DE); Ramesh-Chandran, Aravind, 91056 Erlangen (DE); Appel, Alexander, 91056 Erlangen (DE)
(74) Representative: Valeo Powertrain Systems

(57) **Abstract**

A system (12) for a vehicle, an assembly (10), and a method for detecting a connection state of a switch device (62) of a charging circuit (56) are provided. The system (12) comprises at least one stator coil (30) of an electric machine (18), an inverter (16), and a charging circuit (56). The inverter (16) is configured to be coupled to a battery (14) of the vehicle. The charging circuit (56) is configured to be coupled to a charging device external of the vehicle. The charging circuit (56) is also configured for adapting a charging procedure of a battery (14) of the vehicle. The charging circuit (56) comprises at least a capacitor (64) and a switch device (62). The switch device (62) is arranged between the capacitor (64) and the stator coil (30). A single voltage sensing element (66) is arranged between the switch device (62) of the charging circuit (56) and a star point (60) of the electric machine (18). A control circuit (36) is configured to detect a connection state of the switch device (62) of the charging circuit (56) based on a voltage magnitude measured by the voltage sensing element (66).

## Description

The invention relates to a system for a vehicle, an assembly, and a method for detecting a connection state of a switch device of a charging circuit.

Batteries of hybrid and electric vehicles may commonly be charged through external resources, such as external charging devices. According to some approaches, charging circuits are known which provide selective couplings such that a particular charging path may be activated and deactivated according to the respective needs. These charging circuits comprise switch devices for enabling the selective coupling. Since high charging currents are transferred via the switch devices, appropriate operation of the switch devices must be checked on a regular basis, such as subsequent to each charging procedure.

US 2019/0353708 A1 discloses a system having a charging circuit. Appropriate functioning of the switch device is controlled based on two voltage sensing circuits being arranged and configured such that the voltage amplitudes on opposite sides of the switch device is detected. The multiple voltage sensing circuits cause complex topologies having a large number of components. Therefore, the manufacturing efficiency of these systems is low.

Accordingly, there is a need for a more compact charging topology requiring fewer components and, thereby enabling cabling avoidance and weight reduction.

The subject matter according to the independent claims serves the respective need. Additional embodiments are indicated within the dependent claims and the following description, each of which, individually or in combination, may represent aspects of the invention.

According to an aspect, a system for a vehicle is provided. The system comprises at least one stator coil of an electric machine, an inverter, and a charging circuit. The inverter is configured to be coupled to a battery of the vehicle. The charging circuit is configured to be coupled to a charging device external of the vehicle. The charging circuit is also configured for adapting a charging procedure of a battery of the vehicle. The charging circuit comprises at least a capacitor and a switch device. The switch device is arranged between the capacitor and the stator coil. A single voltage sensing element is arranged between the switch device of the charging circuit and a star point of the electric machine. A control circuit is configured to detect a connection state of the switch device of the charging circuit based on a voltage magnitude measured by the voltage sensing element.

The invention is based on the finding that a single voltage sensing element is sufficient to reliably detect the connection state of the switch device. This is achieved as a particular test signal can be applied for testing the connection state of the switch device. The single voltage sensing device may then be used to detect the response in view of the test signal. This response can be evaluated, whereby the connection state of the switch device is reliably determinable.

Therefore, compared to prior art approaches fewer components are required to evaluate as to whether the switch device functions properly according to the desired needs. Put differently, a single voltage sensing element is sufficient such that fewer cabling is required and such that the weight and the manufacturing expenses can be reduced.

Preferably, the connection state of the switch device relates to either non-conducting or conducting. In the non-conducting state, the switch device is open. In the conducting state, the switch device may be closed or even be welded.

Whether or not the switch device functions properly may be determinable in view of a control signal applied by the control circuit to the switch device such that the switch device is supposed to have a specific connection state. In other words, the control circuit may be configured to adapt a connection state of the switch device of the charging circuit. Accordingly, the control circuit may compare the desired connection state of the switch device with the result of the evaluation based on the voltage sensing element.

In some aspects, the system may be configured to boost a voltage provided by the charging device to the battery. This is achieved as based on the switch device a particular charging path can be selectively enabled such that the charging procedure can occur. For example, the star point of the electric machine can be coupled to the external charging device such that a higher overall charging rate (electrical charging amount per time unit) can be achieved.

Optionally, the inverter comprises multiple switch devices. The control circuit is configured to control the multiple switch devices of the inverter such that predefined voltage pulses are collectively provided by the multiple switch devices of the inverter. The voltage pulses can in particular be regarded reference signals which propagate towards the voltage sensing element depending on the connection state of the switch device. Therefore, by measuring the voltage magnitude using the single voltage sensing element, the connection state of the switch device can be reliably determined at high precision.

In more detail, caused by the impedances of the components of the system, the voltage magnitude measured by the single voltage sensing element may show a specific voltage drop time behavior after a specific voltage pulse has been generated. In this regard, the time behavior of the voltage drop is influenced by the connection state of the switch device. Hence, by evaluating the measured voltage magnitude, the control device can precisely determine the connection state of the switch device.

In some embodiments, the control circuit may comprise a pulse width modulator (in the following PWM) configured to provide control signals to gate drivers of the multiple switch devices of the inverter such that output signals of the multiple switch devices of the inverter are adaptable. The PWM is usable to define respective connection states of the multiple switch devices of the inverter. This enables specific voltage pulses to be generated, such as voltage pulses having specific voltage magnitudes or comprising specific timing properties, e.g. regarding the time period of the pulse. In other words, based on the PWM, a specific control procedure may be executed such that specific reference signals (voltage pulses) are created.

In one aspect, the control circuit may be configured to determine a time constant of a voltage drop detected based on multiple detected values of the voltage magnitude. Based on multiple detected values of the voltage magnitude, the time behavior of the voltage magnitude may be evaluated after a specific voltage pulse was created. As the connection state of the switch device of the charging circuit influences the time behavior, different time constants will be caused depending on whether the switch device is open (non-conducting) or closed (conducting).

Preferably, the control circuit may be configured to determine that the switch device of the charging circuit is open (non-conducting) if the determined time constant is below a first time constant threshold.

Alternatively or cumulatively, the control circuit may be configured to determine that the switch device of the charging circuit is closed (conducting/welded) if the determined time constant exceeds a second time constant threshold.

In some embodiments, the first time constant threshold and the second time constant threshold may be same. In this scenario, the evaluation procedure is compact.

In an alternative, the first time constant threshold and the second time constant threshold may be different. Preferably, the second time constant threshold may be larger than the first time constant threshold. In this scenario, a hysteresis is provided such that a fluctuating evaluation procedure is avoided.

According to an aspect, the stator may comprise multiple stator coils being coupled to each other at the star point. The switch device may be arranged between the star point and a charging unit terminal configured to be coupled to the charging device. In this regard, the charging unit terminal may be part of an onboard charging circuit or a DC/DC converter which directly or rather indirectly may be coupled to the external charging device.

Preferably, the switch device of the charging circuit is a relay or a transistor.

Optionally, the electric machine is a synchronous machine, e.g. an electrically excited synchronous machine. The electric machine can be any electric machine used for traction applications.

According to an aspect, an assembly is provided. The assembly comprises the system as described herein before and a battery of the vehicle. Based on the system, the battery is chargeable with a charging unit terminal at lower voltage. However, the appropriate functioning of the switch device of the charging circuit can be reliably evaluated.

According to a further aspect, a method for detecting a connection state of a switch device of a charging circuit is provided. The charging circuit is configured for adapting a charging procedure of a battery of a vehicle based on a coupling of the charging circuit with a charging device external of the vehicle. The charging circuit comprises at least a capacitor and the switch device. The switch device is arranged between the capacitor and at least one stator coil of the electric machine of the vehicle. An inverter is coupled to the at least one stator coil of the electric machine. The method comprises at least the following steps:
- A first control signal is output by a control circuit. The switch device of the charging circuit is supposed to be open based on the control signal.
- Further control signals are output by the control circuit to switch devices of the inverter such that the switch devices collectively provide a predefined voltage pulse.
- All switch devices of the inverter are deactivated based on the further control signals of the control circuit.
- A voltage magnitude is detected by a single voltage sensing element being arranged between the switch device of the charging circuit and a star point of the electric machine.
- A connection state of the switch device of the charging circuit is determined by the control circuit based on the detected voltage magnitude.

The method provides several advantages which have been explained hereinbefore with regard to the corresponding system. In short, a specific reference signal is provided based on the voltage pulse being generated by the switch devices of the inverter. Since the switch device of the charging circuit is supposed to be open (non-conducting), the detected voltage magnitude can be evaluated in view of the voltage pulse. Since the time behavior of the response to the generated voltage pulse relies on the connection state of the switch device of the charging circuit, this connection state can be reliably determined at high precision and confidence although only a single voltage sensing element is needed. Accordingly, compared to prior art approaches, the system requires fewer components and shows an improved manufacturing and operating efficiency.

Optionally, the voltage magnitude may be detected by the voltage sensing element after waiting a predefined time period subsequent to deactivating the switch devices of the inverter. In this regard, the control circuit may be configured to initiate the sensing procedure executed by the voltage sensing element. In an alternative, the voltage sensing element may continuously detect respective voltage magnitudes but the control circuit may disregard the voltage magnitudes until the predefined time period expired.

The connection state of the switch device of the charging circuit influences the time behavior after the voltage pulse was generated. While the difference may be immediately detectable, the difference causes diverging signal profiles between the distinguishing scenarios of the switch device being closed and the switch device being open. In other words, the difference between the distinguishing signal profiles corresponding to the switch device being closed and the switch device being open increases over time at least for a certain time period which depends, amongst others, on the generated voltage pulse. Therefore, as to this diverging effect, the distinguishing signal profiles can be distinguished from each other at high confidence if an appropriate predefined time period expired after the voltage pulse was generated. Of course, the predefined time period is selected depending on the specific system and the generated voltage pulse such that the different signal profiles can be distinguished from each other at high confidence.

For evaluating the time behavior, the control circuit may determine a time constant of a voltage drop based on multiple detected values of the voltage magnitude. The time constant is compared to at least one time constant threshold. The time constant threshold may correlate to a signal having a profile intermediate between the distinguishing signal profiles explained hereinbefore in view of the different connection states of the switch device of the charging circuit. In other words, the time constant threshold may be chosen such that the corresponding signal profile may be regarded a border for distinguishing the different connection states of the switch device of the charging circuit.

The foregoing aspects and further advantages of the claimed subject matter will become more readily appreciated, as the same become better understood by reference to the following detailed description when taken in conjunction with the accompanying drawings. In the drawings,
- Fig. 1 is a schematic drawing of an assembly according to an embodiment,
- Fig. 2 is a schematic drawing of a method for detecting a connection state of a switch device of a charging circuit according to an embodiment, and
- Fig. 3 is a schematic drawing of different profiles of the detected voltage magnitude depending on the connection state of the switch device of the charging circuit.

All features mentioned below in relation to the embodiments and/or the accompanying figures may be used alone or in any sub-combination with combination with features of the invention, including features of preferred of preferred embodiments.

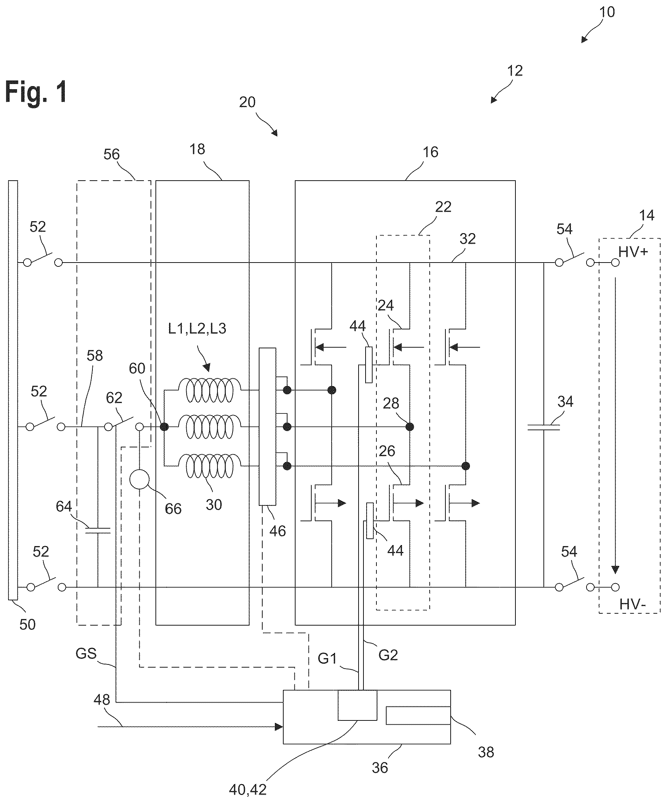

Fig. 1 is a schematic drawing of an assembly 10 according to an embodiment. The assembly 10 comprises a system 12 for a vehicle according to an embodiment and a battery 14 of the vehicle, preferably a high-voltage battery.

The system 12 comprises an inverter 16 and an electric machine 18. The inverter 16 and the electric machine 18 may be regarded to establish a drive unit 20 of the vehicle.

The inverter 16 is generally arranged to provide supply signals for the electric machine 18 so that a torque can be output by the electric machine 18 for a component of the vehicle, for example for driving.

In the illustrated embodiment, the inverter 16 comprises a B6 bridge having three half-bridges 22. The following functionality is illustrated with reference to only one half-bridge 22, but applies accordingly to all half-bridges 22 of the B6 bridge.

Each half-bridge 22 includes a first switch device 24, such as a transistor, that functions as a high-side power switch, and a second switch device 26, such as a transistor, that functions as a low-side power switch.

The transistors may be metal oxide semiconductor field effect transistors (MOSFETs), insulated gate bipolar transistors (IGBTs), or silicon carbide or gallium nitride field effect transistors (SiC or GaN FETs).

Between the first switch device 24 and the second switch device 26, each half-bridge 22 comprises a center node 28 for outputting a voltage signal to a stator coil 30 of the electric machine 18, in this case L2.

Three corresponding current signals, L1, L2 and L3, are applied to the multiple stator coils 30 of the electric machine 18 via the three half-bridges 22 such that an alternating current is established (driven) within the stator coils 30 of the electric machine 18.

Contrary to the three-phase topology of the electric machine 18 of the present embodiment, other topologies are possible as well, which then require corresponding modifications to the inverter 16, for example a six-phase electric machine 18, a multilevel inverter.

The respective half-bridges 22 are coupled to a busbar structure 32 of the inverter 16. The inverter 16 is coupled to the battery 14 which represents a DC source. The DC source comprises terminals between which a high voltage HV is provided, for example with a voltage amplitude of 100 V or more, in particular 400 V or 800 V.

In addition, the inverter 16 comprises a DC link capacitor 34, which serves as a coupling element between the battery 14 and the electric machine 18. The DC link capacitor 34 ensures that the supply signals are more uniform with regard to the current amplitude and/or the voltage amplitude, for example in the case of varying load conditions caused by different torques output by the electric machine 18.

To control the switching states of the switch devices 24, 26, the assembly 10 comprises a control circuit 36. The control circuit 36 may also be regarded being part of the drive unit 20 or at least being assigned to the inverter 16 and/or the electric machine 18. The control circuit 36 comprises at least one data processing circuit 38.

The control circuit 36 is configured to provide corresponding control signals G1, G2 for the switch devices 24, 26 of the inverter 16 such that the switching positions of the switch devices 24, 26 are influenced on the basis of these control signals. The control signals G1, G2 depend on a modulation signal 40 that is determined by means of a pulse width modulator 42.

The control signals G1, G2 are output to gate driver circuits 44, which are coupled to the gate electrodes of the switch devices 24, 26. Based on the control signals G1, G2, the gate driver circuits 44 generate corresponding gate signals to influence the switching states of the switch devices 24, 26 between closed (conducting) and open (non-conducting).

For determining the respective control signals G1, G2 and in order to achieve a desired operation of the electric machine 18, the control circuit 36 is coupled to current sensors 46 which are arranged between the center nodes 28 of the half-bridges 22 and the stator coils 30 of the electric machine 18. The current sensors 46 are configured to detect the current amplitudes output by the half-bridges 22 of the inverter 16 to the electric machine 18, notably the waveform of such current, and to transmit the detected current amplitude values to the control circuit 36.

The control circuit 36 may generally be coupled to further components of the assembly 10. In some embodiments, the control circuit 36 may be coupled to the electric machine 18, and/or a rotor sensor configured to detect a position of a rotor of the electric machine 18 relative to the stator, and/or the battery 14.

The control circuit 36 can then output corresponding control signals G1, G2, for example as a function of the rotor position. As a result, the stator coils 30 of the electric machine 18 are supplied with corresponding current signals. The precise control of the electric machine 18 and, thus, the characteristics of the control signals G1, G2 generally depend on a torque request 48 that the control circuit 36 receives from a higher-level component of the vehicle. The torque request 48 indicates which output torque is to be provided by the electric machine 18. For example, the torque request 48 may depend on a pedal position of a pedal of the vehicle.

During operation of the assembly 10, the charging level of the battery 14 falls. Therefore, the battery 14 needs to be charged from time to time. In this regard, the assembly 10 comprises a charging unit terminal 50. The charging unit terminal 50 may be regarded an output of a DC/DC converter or an onboard charging circuit of the vehicle. Via the charging unit terminal 50, the battery 14 may be indirectly coupled to a charging device external of the vehicle, such as a charging station, a wall box, or a power socket.

For charging, the battery 14 can be coupled to the charging unit terminal 50 via the busbar structure 32,comprising a positive busbar and a negative busbar, and respective groups of switch devices 52, 54 assigned to the charging unit terminal 50 and the battery 14. Usually, the individual switch devices of the separate groups of the switch devices 52 assigned to the charging unit terminal 50 and the switch devices 54 assigned to the battery 14 are activated or deactivated group-wise between closed and open.

In order to achieve the charging procedure, the assembly 10 and the system 12 additionally comprise a charging circuit 56 arranged between the charging unit terminal 50 and the electric machine 18.

The charging circuit 56 generally provides an additional electrical connection 58 between the charging unit terminal 50 and the star point 60 of the electric machine 18 at which the stator coils 30 are coupled to each other.

The electrical connection 58 can be selected between conducting (closed; activated) and non-conducting (open; deactivated) based on a switch device 62 of the charging circuit arranged between the switch devices 52 assigned to the charging unit terminal 50 and the star point 60 of the electric machine 18. In particular, if the switch devices 52 of the group assigned to the charging unit terminal 50 are collectively controlled (closing the one associated to the star point and the one associated to the negative busbar and opening the one associated to the positive busbar) , the charging circuit 56 is required to comprise the separate switch device 62 in order to provide a possibility of a controlled activation mechanism of the electrical connection 58 established by the charging circuit 56.

The connection state of the switch device 62 of the charging circuit 56 is controlled by the control circuit 36 based on the control signal GS.

The switch device 62 of the charging circuit 56 may be a relay or a transistor.

The charging circuit 56 also comprises a capacitor 64 coupled between the electrical connection 58 and the busbar structure 32. The capacitor 64 is coupled to an input side of the switch device 62 of the charging circuit 56, i.e. to a side which is assigned to the charging unit terminal 50.

During the charging procedure for enhancing the charging level of the battery 14, charging currents with high amplitudes are transferred across the switch device 62 of the charging circuit 56.

In order to control appropriate functioning of the switch device 62 of the charging circuit 56, such as for excluding that no welding of the switch device 62 is caused by a charging procedure, the system 12 comprises a single voltage sensing element 66 being coupled between the switch device 62 and the star point 60 of the electric machine 18. The single voltage sensing element 66 is configured to detect a voltage magnitude at the output side of the switch device 62, i.e. at the side assigned to the star point 60 of the electric machine 18 opposite from the input side of the switch device 62 to which the capacitor 64 of the charging circuit 56 is coupled.

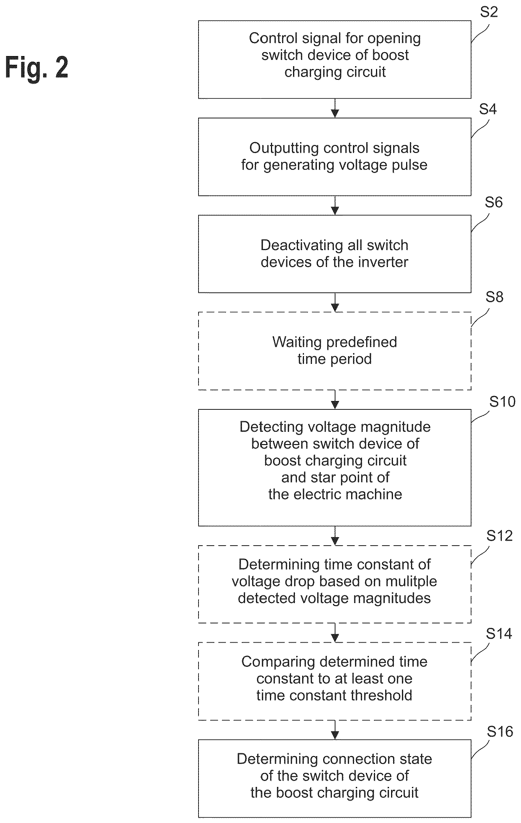

Fig. 2 is a schematic drawing of a method for detecting a connection state of the switch device 62 of the charging circuit 56 according to an embodiment. Optional steps are shown in dashed lines.

According to step S2, the first control signal GS is output by a control circuit 36. Based on the first control signal GS, the switch device 62 of the charging circuit 56 is supposed to be open (non-conducting).

In subsequent step S4, further control signals G1, G2 are output by the control circuit 36 to the switch devices 24, 26 of the inverter 16 such that the switch devices 24, 26 collectively provide a predefined voltage pulse. It is assumed that the charging level of the battery 14 is sufficient such that the voltage pulse can be generated. Based on the control signals G1, G2, the control circuit 36 may control the switch devices 24, 26 of the inverter 16 such that the generated voltage pulse comprises desired properties, such as a specific pulse length and a specific voltage amplitude.

After the voltage pulse is generated, all switch devices 24, 26 of the inverter 16 are deactivated in step S6 based on the control signals G1, G2 of the control circuit 36. This means that the stator coils 30 of the electric machine 18 are disconnected from the battery 14.

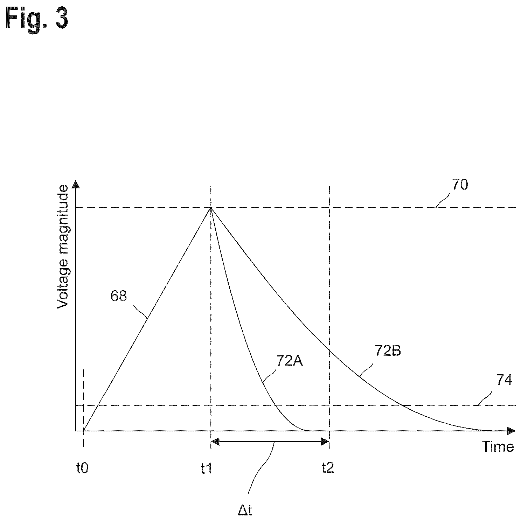

According to subsequent optional step S8, a predefined time period is waited after the switch devices 24, 26 of the inverter 16 are deactivated. The predefined time period can be selected such that the detection precision and confidence are high, which will be explained in more detail below with reference to Fig. 3.

According to the following step S10, a voltage magnitude is detected by the single voltage sensing element 66 being arranged between the switch device 62 of the charging circuit 56 and a star point 60 of the electric machine 18. Of course, it may be that the single voltage sensing element 66 continuously detects the respective voltage magnitude and that the control circuit 36 simply disregards the detected values in order to take the predefined time period of optional step S8 into account. In an alternative, the actual detection of the voltage magnitude may be initiated by the control circuit 36, for example after the predefined time period expired.

In subsequent optional step S12, the control circuit 36 takes into account multiple detected values of the detected voltage magnitude in order to determine a time constant of a voltage drop occurring after the voltage pulse was generated. Based on the intrinsic impedances of the system 12, such as the impedances of the stator coils 30 of the electric machine 18, such as the passive discharge resistor of the capacitor 64 or of the Dc link capacitor 34, such as the resistor cascade of the voltage sensing element 66, the voltage amplitude caused by the generated voltage pulse falls over a respective time period thereby establishing a voltage drop which can be detected based on multiple values of the measured voltage magnitude. The time characteristics of the voltage drop, such as the time constant is influenced by the connection state of the switch device 62 of the charging circuit 56, i.e. by the property as to whether the switch device 62 is closed (conducting) or open (non-conducting). This influencing effect is at least partially caused by the capacitor 64 of the charging circuit 56 being coupled or not being coupled via the switch device 62 to the single voltage sensing element 66. Therefore, the multiple detected values of the voltage magnitude will cause different time constants of the voltage drop depending on the connection state of the switch device 62.

In the following optional step S14 the control circuit 36 compares the determined time constant of the voltage drop of optional step S12 to at least one time constant threshold. The time constant threshold is selected accordingly such that the separate connection states of the switch device 62 of the charging circuit 56 can be distinguished from each other.

The method also comprises step S16 in which a connection state of the switch device 62 of the charging circuit 56 is determined by the control circuit 36 based on the detected voltage magnitude. For example, the comparison of the optional step S14 can be taken into account in this regard. In an alternative, the detected voltage magnitude can also be compared to voltage magnitude threshold values omitting the determination of a time constant. In any case, based on the detected voltage magnitude, the connection state of the switch device 62 can be determined between closed (conducting) and open (non-conducting).

Fig. 3 is a schematic drawing of different signal profiles 72A, 72B of the detected voltage magnitude depending on the connection state of the switch device 62 of the charging circuit 56.

On the y-axis the voltage magnitude detected by means of the single voltage sensing element 66 being arranged between the switch device 62 and the star point 60 of the electric machine 18 is shown over the time on the x-axis.

At time t0, the voltage pulse is generated based on the control signals G1, G2 output by the control circuit 36 to the switch devices 24, 26 of the inverter 16. Accordingly, the voltage magnitude shows a rise 68 towards the target voltage 70 until the time t1 at which the switch devices 24, 26 of the inverter are deactivated (opened).

Subsequently, the generated voltage amplitude falls and shows a voltage drop from the target voltage 70. Depending on the connection state of the switch device 62 of the charging circuit 56, the signal profiles 72A, 72B distinguish from each other. In other words, the characteristics of the voltage drop following the generated voltage pulse are different in view of the switch device 62 being conducting (closed) or non-conducting (open). In particular, if the switch device 62 is non-conducting (open), the signal profile 72A caused has a steeper slope than the slope of the signal profile 72B corresponding to the switch device 62 being conducting (closed). Therefore, the signal profile 72A corresponds to a smaller time constant than the signal profile 72B. Accordingly, the control circuit 36 can determine a time constant based on multiple detected values of the voltage magnitude and compare the determined time constant to respective time constant thresholds in order to distinguish the different connection states of the switch device 62.

Also, the difference of the signal profiles 72A, 72B increases over time. Therefore, in an alternative or in addition, the control circuit 36 can wait a predefined time period Δt after the switch devices 24, 26 were deactivated until the time t2 and distinguish the connection state of the switch device 62 of the charging circuit 56 based on a single detected value of the voltage magnitude at the time t2. As to the different slopes of the signal profiles 72A, 72B, the different connection states of the switch device 62 can be efficiently distinguished from each other. Generally, the predefined time period Δt depends on the characteristic properties of the system 12 and the assembly 10 and is chosen accordingly.

The assembly 10, the system 12, and the method enable the connection state of the switch device 62 of the charging circuit 56 to be reliably determinable based on a single voltage sensing element 66. Therefore, the operating and production efficiencies are high.

## Claims

1. A system (12) for a vehicle, the system (12) comprising at least one stator coil (30) of an electric machine (18), an inverter (16), and a charging circuit (56), wherein the inverter (16) is configured to be coupled to a battery (14) of the vehicle, wherein the charging circuit (56) is configured to be coupled to a charging device external of the vehicle, wherein the charging circuit (56) is also configured for adapting a charging procedure of a battery (14) of the vehicle,
wherein the charging circuit (56) comprises at least a capacitor (64) and a switch device (62), wherein the switch device (62) is arranged between the capacitor (64) and the stator coil (30),
wherein a single voltage sensing element (66) is arranged between the switch device (62) of the charging circuit (56) and a star point (60) of the electric machine (18), and
wherein a control circuit (36) is configured to detect a connection state of the switch device (62) of the charging circuit (56) based on a voltage magnitude measured by the voltage sensing element (66).

2. The system (12) of claim 1, wherein the inverter (16) comprises multiple switch devices (24, 26), and wherein the control circuit (36) is configured to control the multiple switch devices (24, 26) of the inverter (16) such that predefined voltage pulses are collectively provided by the multiple switch devices (24, 26) of the inverter (16).

3. The system (12) of claim 1 or 2, wherein the control circuit (36) comprises a pulse width modulator (42) configured to provide control signals to gate driver circuits (44) of the multiple switch devices (24, 26) of the inverter (16) such that output signals of the multiple switch devices (24, 26) of the inverter (16) are adaptable.

4. The system (12) of any one of the preceding claims, wherein the control circuit (36) is configured to determine a time constant of a voltage drop detected based on multiple detected values of the voltage magnitude.

5. The system (12) of claim 4, wherein the control circuit (36) is configured to determine that the switch device (62) of the charging circuit (56) is open if the determined time constant is below a first time constant threshold, and/or
wherein the control circuit (36) is configured to determine that the switch device (62) of the charging circuit (56) is closed if the determined time constant exceeds a second time constant threshold.

6. The system (12) of any one of the preceding claims, wherein the control circuit (36) is configured to adapt a connection state of the switch device (62) of the charging circuit (56).

7. The system (12) of any one of the preceding claims, wherein a stator of the electric machine (18) comprises multiple stator coils (30) being coupled to each other at the star point (60), and
wherein the switch device (62) is arranged between the star point (60) and a charging unit terminal (50) configured to be coupled to the charging device.

8. An assembly (10) comprising the system (12) according to any one of the preceding claims and a battery (14) of the vehicle.

9. A method for detecting a connection state of a switch device (62) of a charging circuit (56) configured for adapting a charging procedure of a battery (14) of a vehicle based on a coupling of the charging circuit (56) with a charging device external of the vehicle,
wherein the charging circuit (56) comprises at least a capacitor (64) and the switch device (62), wherein the switch device (62) is arranged between the capacitor (64) and at least one stator coil (30) of the electric machine (18) of the vehicle, wherein an inverter (16) is coupled to the at least one stator coil (30) of the electric machine (18),
wherein the method comprises at least the following steps:
- outputting a first control signal by a control circuit (36), wherein the switch device (62) of the charging circuit (56) is supposed to be open based on the control signal,
- outputting further control signals by the control circuit (36) to switch devices (24, 26) of the inverter (16) such that the switch devices (24, 26) collectively provide a predefined voltage pulses,
- deactivating all switch devices (24, 26) of the inverter (16) based on the further control signals of the control circuit (36),
- detecting a voltage magnitude by a single voltage sensing element (66) being arranged between the switch device (62) of the charging circuit (56) and a star point (60) of the electric machine (18), and
- determining a connection state of the switch device (62) of the charging circuit (56) by the control circuit (36) based on the detected voltage magnitude.

10. The method of claim 9, wherein the voltage magnitude is detected by the voltage sensing element (66) after waiting a predefined time period subsequent to deactivating the switch devices (24, 26) of the inverter (16).

11. The method of claim 9 or 10, wherein the control circuit (36) determines a time constant of a voltage drop based on multiple detected values of the voltage magnitude, and wherein the time constant is compared to at least one time constant threshold.
